# EUROPEAN PATENT APPLICATION

(11) **EP 1 852 909 A1**
(43) Date of publication of application: **07.11.2007**
(21) Application number: 06009365.5
(22) Date of filing: 05.05.2006
(51) Int. Cl.: H01L 21/8247, H01L 27/105, H01L 29/423, H01L 21/336

(54) **Process for integrating a non-volatile memory cell into a HV CMOS process**

(71) Applicant: austriamicrosystems AG, 8141 Unterpremstätten (AT)
(72) Inventor: Leisenberger, Friedrich Peter, 8045 Graz (AT); Park, Jong Mun, 8010 Graz (AT)
(74) Representative: Epping - Hermann - Fischer

(57) **Abstract**

A process is given which can integrate the production of an EEPROM cell into a CMOS process without deteriorating the oxide quality of the CMOS gate oxides. It proposed the EEPROM floating gate (PS1) and the covering intermediate dielectric (10) is formed first and protected with a silicon nitride layer (SN) before forming the gate oxide areas of the CMOS structure.

## Description

The invention relates to a process for manufacturing a device comprising at least one MOS FET transistor and a non-volatile memory cell. Such devices are useful for programmable logic circuits especially for ASICS.

In order to integrate a non volatile memory cell into a high voltage CMOS technology it is necessary to form different gate oxides of different thicknesses e.g. up to five and more different gate oxides may be necessary. Beside gate oxide and mid gate oxide, a high voltage gate oxide for example has to have an excellent quality. Therefore the number of etch or masking steps on this oxide has to be minimized.

On the other side, forming the intermediate dielectric between floating gate and control gate needs a good control of oxide thickness. Normally the polysilicon floating gates of the EEPROM will oxidize during the oxide growth process of the CMOS structure and thus the EEPROM high voltage gate oxide regions will end up with a too thick oxide slowing down the maximum operation speed of the EEPROM. It is further necessary that processing the EEPROM cell does not deteriorate the oxide quality of the CMOS structure.

It is an object of the invention to combine the two different manufacturing processes for a CMOS structure and an EEPROM cell and avoiding the above mentioned disadvantages.

This object is reached by a process according to claim 1. Further embodiments are subjects of dependent subclaims.

According to the invention the formation of the EEPROM cell has to take place before the gate oxide growth e.g. a high voltage gate oxide. To prevent the polysilicon floating gates of the EEPROM from oxidizing during the oxide growth process of the CMOS structure it is proposed protected same. According to the invention this protection is achieved by covering these regions with a non oxidizing protection layer (e.g. silicon nitride) to prevent oxidation. After the growth of the high voltage gate oxide the protection layer can be removed and the normal manufacturing process flow of the CMOS structure is continued.

The proposed manufacturing process comprises the following steps which can be successfully performed in the given sequence:
- forming on a substrate first and second active areas of the non volatile memory cell and the CMOS transistor respectively
- forming a thin tunnel oxide in the first active area
- forming a floating gate above the tunnel oxide
- forming an intermediate dielectric encapsulating said floating gate
- forming a silicon nitride layer above said intermediate oxide totally covering the first active area
- forming at least one gate oxide of the CMOS transistor having a thickness different from the intermediate dielectric
- removing said silicon nitride layer and completing the CMOS transistor and the non volatile memory cell structure.

In this process the gate oxides have to suffer only the step of stripping of resists and of removing said silicon nitride layer. Structuring of the floating gate is performed before the gate oxide formation to spare the gate oxides the polysilicon etch.

In one embodiment, after removing the protection layer and the resists layer all oxides produced are subjected to a common thermal oxidation step thereby healing possible defects in the oxide structures and raising the thickness of the oxide structures to the desired values. During this step a further oxide of a thickness which is small with respect to the other gate oxides may be formed on a silicon surface in a third active area. The healing of the oxides is performed until the desired thickness of the oxide in the third active area is reached.

All oxide forming processes i.e. the steps of forming the tunnel oxide, the intermediate dielectric and the gate oxide of the CMOS transistor may be performed by thermal oxidation. It is also possible to form a part of the total oxide thickness by vapour or plasma deposition. In these cases it is preferred that the last step forming the oxides is a thermal oxidation step healing all possible defects which may be produced during oxide deposition.

According to an embodiment at least a third active area is formed for producing a second or a further CMOS transistor therein. In doing this the step of forming the gate oxide of the CMOS transistor may comprise the following steps
- forming a first oxide layer in the second and third active area,
- covering the first oxide layer in the second active area with a resist
- removing the first oxide layer in the third active area,
- striping the resist
- thickening the first oxide layer in the second active area and forming a second oxide layer in the third active area by thermal oxidation.

The oxide thickness in the second active area is thus the sum of the first oxide layer thickness and the amount resulting from thickening. While removing the first oxide layer in the third active area, it is possible to stop this removing, which is usually a wet etching step but may be also a dry etch step, at a given remaining oxide layer thickness. But totally removing the oxide layer is a process which can be better controlled. Stripping the resist does not deteriorate the oxide quality there below. The more so as the following oxidation step heals any defects.

This step sequence results in different oxide layer thicknesses in the second and the third active area providing different gate oxides for different transistors operating at different voltages. One of the transistors may be a high voltage transistor working at a voltage of 20V for example. This transistor can be used as a selection transistor for the EEPROM cell. According to the desired functions of the device the operating voltage may even be higher.

It is advantageous that the transistor formed in the second active area is the transistor operating with the highest voltage as this transistor can be processed with the highest gate oxide thickness.

After removing the silicon nitride layer a further step of a thermal oxidation to densify the intermediate dielectric can follow. This step can be combined with the before mentioned step of thickening the oxide layer in the second and forming the (new) the oxide in the third active area.

The total process starts with defining the active areas of the transistors and other structures to be produced in the substrate. Field oxide areas are produced by thermal oxidation of the substrate. The active areas which are to be prevented from oxidation are covered with a protection layer usually a silicon nitride layer. Thus, after removing the protection layer the Field oxide areas are surrounding the active areas and each active area is defined and isolated against adjacent active areas by this field oxide. Alternatively shallow trench isolation can be used to define the active areas.

Wells in the semiconductor substrate may be formed before and/or after the field oxide formation for isolating the transistors to be produced later therein against substrate.

After forming all gate oxides in the desired or necessary thicknesses as described above the gates are produced. This can be done by depositing a polysilicon layer and structuring the layer.

Next step is forming the polysilicon 2 plane comprising the steps of depositing a layer of polysilicon in a thickness necessary for the control gate of the EEPROM cell, structuring the polysilicon 2 layer and forming spacers at the side edges of the multilayer stack comprising floating gate, intermediate dielectric and control gate as well as at the gates of the CMOS transistors.

The further completing of the CMOS transistor and the EEPROM cell is made by standard procedures which are well known and described elsewhere.

In the following the process is described in more detail with respect to the accompanied drawings. The figures are only schematic and not drawn to scale.

Figure 1 to 7 show schematic cross sections of an electronic device at different stages of processing.

Figure 8 shows the sequence of process modules.

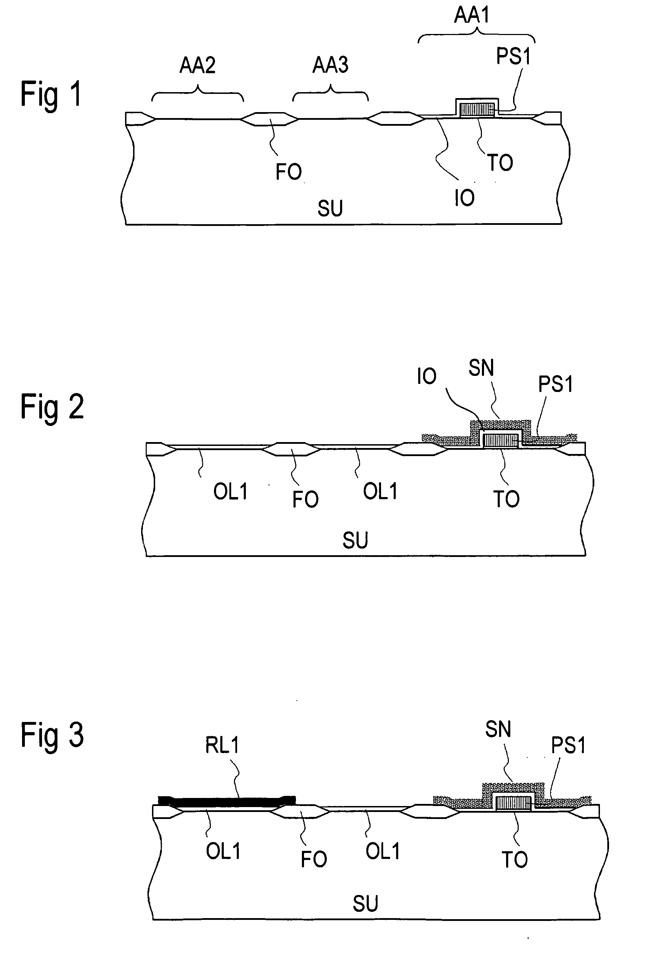

Isolating wells for the transistor structures are formed in a silicon substrate SU (not shown in the figures). Then at least three active areas AA1, AA2 and AA3 are defined by forming field oxide areas FO or shallow trench isolations (not shown in the figure). A thin tunnel oxide TO for the EEPROM cell is formed and structured to remain in the first active area AA1 only. A first polysilicon layer is deposited and structured to form the floating gate PS1 in the first active area AA1. The intermediate dielectric IO is produced by thermal growth and depositing silicon oxide up to a first thickness and then thickening it to a second thickness. The oxide is then masked and etched back to remain only in the first active area AA1. Figure 1 shows the device after this step.

A silicon nitride protection layer SN is deposited and structured to only cover the first active area AA1. Next, a first oxide layer OL1 is formed in the remaining active areas AA2 and AA3 where the silicon of the substrate SU is exposed. Figure 2 shows the device after this step.

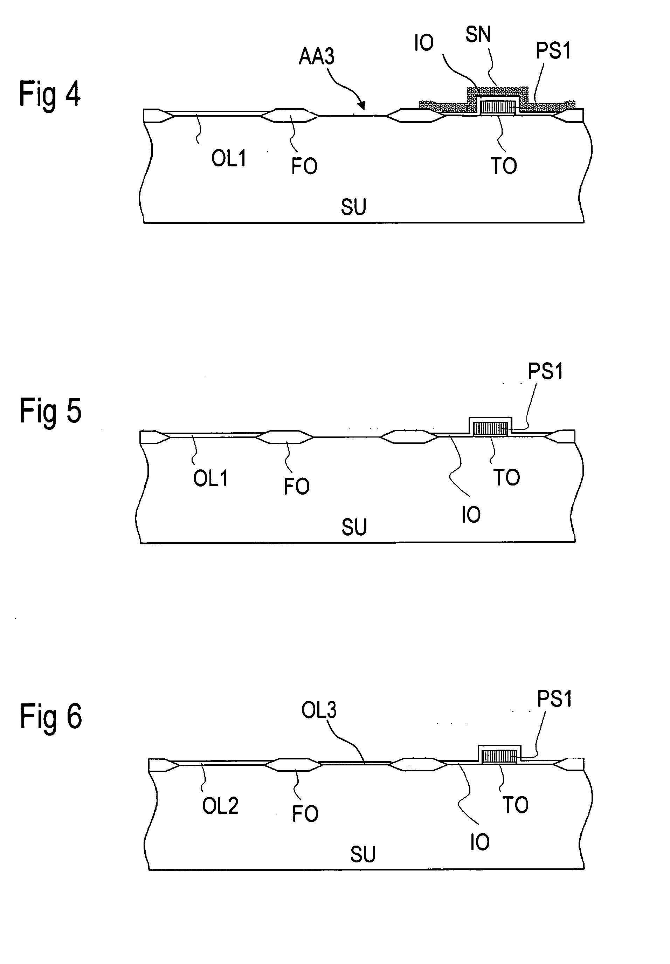

Now a resist layer RL is produced to cover only the oxide layer OL1 in the second active area AA2 as shown in figure 3. Exposed areas of the oxide layer OL1 are then removed by wet etch or plasma etch to expose the silicon surface in the third active area AA3. Figure 4 shows the device after stripping the resist RL1.

Figure 5 shows the device after removing the silicon nitride SN. Exposed silicon substrate in the third active area AA3 is oxidized to produce a third oxide layer OL3 there. Remaining first oxide OL1 and intermediate dielectric are thickened up by this step. Figure 6 shows the device after this step showing a oxide layer OL2 of a second higher thickness in the first active area and a newly formed third oxide layer OL3 of a third small thickness in the third active area AA3.

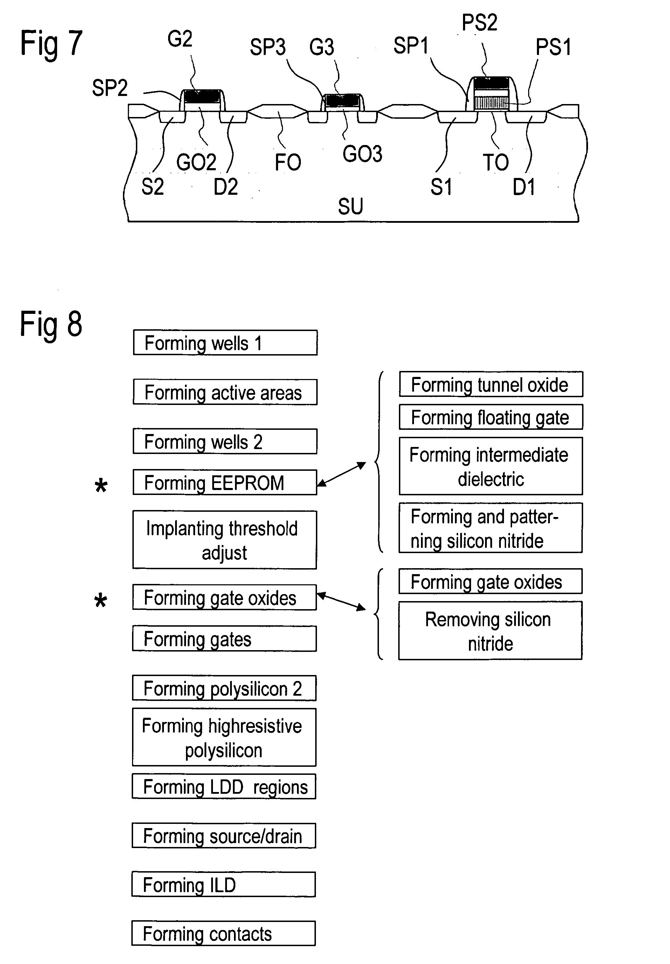

Figure 7 shows the device after proceeding further steps as already described above. In second and third active area AA2, AA3 two CMOS transistors have been completed by forming gates G2, G3, spacers SP2, SP3 and by doping source and drain regions S,D. Different gate oxide thickness allows to operate these two transistors with different voltages. At the EEPROM cell the control gate PS2 and further spacers SP1 are formed.

Figure 8 shows the sequence of process modules necessary to manufacture the device comprising at least one CMOS structure and a EEPROM cell. In the left column the modules are listed of which the two modules characterized with an asterix are new (first module) or modified (second module) with respect to a known CMOS process sequence. These new modules each comprise a series of different steps which are listed in the right column.

The invention is not restricted to the exemplary embodiments and figures and may be modified without leaving the scope of the claims. Further transistors which may have a deviating gate oxide thickness may be formed according to the given process sequence. The arrangement of the device areas may be different and comprise further structure elements not belonging to the mentioned one but part of the circuit formed in the device.

## Claims

1. A process for integrated manufacture of a non volatile memory cell and a CMOS transistor, comprising the following steps
- forming on a substrate first and second active areas of the non volatile memory cell and the CMOS transistor
- forming a thin tunnel oxide in the first active area
- forming a floating gate above the tunnel oxide
- forming an intermediate dielectric encapsulating said floating gate
- forming a silicon nitride layer above said intermediate oxide totally covering the first active area
- forming at least one gate oxide of a CMOS transistor having a thickness different from the intermediate dielectric
- removing said silicon nitride layer and completing the CMOS transistor and the non volatile memory cell structure.

2. The process of claim 1,
wherein the steps of forming the tunnel oxide, the intermediate dielectric and the gate oxide of the CMOS transistor each comprise the step of a thermal oxidation and/or the step of depositing silicon oxide.

3. The process of claim 1 or 2,
wherein at least a third active area is formed for a second CMOS transistor,
the step of forming the gate oxide of the CMOS transistor further comprising
- forming a first oxide layer in the second and third active area,
- covering the first oxide layer in the second active area with a resist
- removing the first oxide layer in the third active area,
- striping the resist
- thickening the first oxide layer (OL1) in the second active area (AA2) and forming a second oxide layer (OL3) in the third active area by thermal oxidation.

4. The process of one of claims 1 to 3,
wherein after removing the silicon nitride layer (SN) a further step of a thermal oxidation for thickening the intermediate dielectric (IO) follows.

5. The process of one of claims 1 to 4,
wherein the steps of thickening the first oxide layer (OL1) in the second active area (AA2) and forming a second oxide layer (OL3) in the third active area (AA3) and thickening the intermediate dielectric (IO) are processed at the same time.

6. The process of one of claims 1 to 5,
wherein the first or the second CMOS transistor is a high voltage transistor.

7. The process of one of claims 1 to 6,
wherein forming an active area (AA) comprises defining a field oxide area (FO) surrounding each active area (AA) and forming a field oxide therein by thermal oxidation.

8. The process of one of claims 1 to 6,
wherein forming an active area (AA) comprises defining and forming a a shallow trench isolation surrounding each active area (AA).

9. The process of one of claims 1 to 8,
wherein completing the structure of the CMOS transistor structure comprises forming gate structures over the gate oxides at first and second active areas, forming a lightly doped drain region, a spacer and source and drain regions.

10. The process of one of claims 1 to 9,
wherein completing the structure of the non-volatile memory cell comprises forming a control gate above the intermediate dielectric forming a lightly doped drain region, forming spacers at side edges of the gate structure comprising floating gate, intermediate dielectric and control gate as well as at the side of the CMOS gate, forming source and drain.

11. The process of claim 10,
wherein the step of forming the gate structures is performed before forming the control gate.
